# EUROPEAN PATENT APPLICATION

(11) **EP 4 199 031 A1**
(43) Date of publication of application: **21.06.2023**
(21) Application number: 21215700.2
(22) Date of filing: 17.12.2021
(51) Int. Cl.: H01J 37/22

(54) **CHARGED-PARTICLE OPTICAL APPARATUS AND PROJECTION METHOD**

(71) Applicant: ASML Netherlands B.V., 5500 AH Veldhoven (NL)
(72) Inventor: SCOTUZZI, Marijke, 5500 AH Veldhoven (NL); MANGNUS, Albertus, Victor, Gerardus, 5500 AH Veldhoven (NL); REN, Yan, 5500 AH Veldhoven (NL); SMAKMAN, Erwin, Paul, 5500 AH Veldhoven (NL)
(74) Representative: ASML Netherlands B.V.

(57) **Abstract**

A charged-particle optical apparatus configured to project a multi-beam of charged particles, the apparatus comprising:
a charged particle device switchable between (i) an operational configuration in which the device is configured to project the multi-beam to a sample along an operational beam path extending from a source of the multi-beam to the sample and (ii) a monitoring configuration in which the device is configured to project the multi-beam to a detector along a monitoring beam path extending from the source to the detector;
wherein the monitoring beam path diverts from the inspection beam path part way along the operational beam path.

## Description

### FIELD

The embodiments provided herein generally relate to charged-particle optical apparatuses and projection methods, and particularly to charged-particle optical apparatuses and projection methods that use multiple sub-beams of charged particles.

### BACKGROUND

When manufacturing semiconductor integrated circuit (IC) chips, undesired pattern defects often occur on a substrate (i.e. wafer) or a mask during the fabrication processes, thereby reducing the yield. Such defects can occur as a consequence of, for example, optical effects and incidental particles as well as in subsequent processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve characteristics of a charged-particle optical apparatus. In particular, it is desirable to monitor various characteristics of the beam of charged particles, for example to provide a foundation for the beam to be controlled to have desirable characteristics. This is a process that needs to be improved.

### SUMMARY

The embodiments provided herein disclose a charged-particle optical apparatus and a projection method.

According to a first aspect of the invention, there is provided a charged-particle optical apparatus configured to project a multi-beam of charged particles, the apparatus comprising:
a charged particle device switchable between (i) an operational configuration in which the device is configured to project the multi-beam to a sample along an operational beam path extending from a source of the multi-beam to the sample and (ii) a monitoring configuration in which the device is configured to project the multi-beam to a detector along a monitoring beam path extending from the source to the detector;
wherein the monitoring beam path diverts from the inspection beam path part way along the operational beam path.

According to a second aspect of the invention, there is provided a charged-particle optical apparatus configured to project a multi-beam of charged particles to a sample, the apparatus comprising:
a source configured to output a source beam for generation of the multi-beam;
an aperture array configured to form a plurality of beams of the multi-beam from the source beam by blocking a proportion of the source beam from being projected towards the sample; and
a detector configured to measure at least a parameter of at least part of the blocked proportion of the source beam.

According to a third aspect of the invention, there is provided a charged-particle optical apparatus configured to project a multi-beam of charged particles to a sample, the apparatus comprising:
a charged-particle device comprising:
   an objective lens array configured to project the multi-beam onto locations on the sample;
   a plurality of converters configured to receive signal particles emitted from the sample and to generate light in response to the received signal particles; and
   a light guiding arrangement comprising a mirror defining a plurality of apertures to allow passage of the multi-beam through the mirror towards the sample; and
a light sensing assembly to which the light guiding arrangement is configured to guide the light generated by the converters, wherein the light sensing assembly comprises:
   an assessment sensor and a detector each configured to detect the light generated by the converters; and
   a beam splitter configured to split the light generated by the converters into light beams for the assessment sensor and the detector.

According to a fourth aspect of the invention, there is provided a method to project a multibeam of charged particles, the method comprising:
using a charged particle device in an operational configuration to project the multi-beam to a sample along an operational beam path from a source of the multi-beam to the sample; and
using the device in a monitoring configuration to project the multi-beam to a detector along a monitoring beam path extending from the source to the detector;
wherein the monitoring beam path diverts from the operational beam path part way along the operational beam path.

According to a fifth aspect of the invention, there is provided a method of projecting a multi-beam of charged particles, the method comprising:
in an operational configuration projecting the multi-beam to a sample along an operational beam path from a source of the multi-beam to the sample; and
in a monitoring configuration projecting the multi-beam to a detector along a monitoring beam path from the source to the detector and diverting the monitoring beam path from the operational beam path part way along the operational beam path.

According to a sixth aspect of the invention, there is provided a method to project a multibeam of charged particles to a sample, the method comprising:
using a source to output a source beam of the multi-beam;
using an aperture array to form a plurality of beams of the multi-beam from the source beam by blocking a proportion of the source beam from being projected towards the sample; and
using a detector to measure at least a parameter of at least part of the blocked proportion of the source beam.

According to a seventh aspect of the invention, there is provided a method of projecting a multi-beam of charged particles to a sample, the method comprising:
outputting a source beam of the multi-beam form a source;
forming a plurality of beams of the multi-beam from the source beam by blocking at an aperture array a proportion of the source beam from being projected towards the sample; and
measuring at least part of the blocked proportion of the source beam, desirably using a detector.

According to an eighth aspect of the invention, there is provided a method to project a multi-beam of charged particles to a sample, the method comprising:
using an objective lens array configured to project the multi-beam onto locations on the sample;
using a plurality of converters, desirably scintillators, to receive signal particles emitted from the sample and to generate light in response to the received signal particles;
using a light guiding arrangement to guide the light generated by the converters to a light sensing assembly, wherein the light guiding arrangement comprises a mirror defining a plurality of apertures to allow passage of the multi-beam through the mirror towards the sample; and
using a beam splitter to split the light generated by the converters into a plurality of light beams for an assessment sensor and a detector; and
using the assessment sensor and the detector to detect the light generated by the converters.

According to a ninth aspect of the invention, there is provided a method of projecting a multi-beam of charged particles to a sample, the method comprising:
projecting the multi-beam onto locations on the sample, desirably using an objective lens array;
receiving signal particles emitted from the sample and generating light in response to the received signal particles, desirably using a plurality of converters, desirably scintillators;
guiding the light generated to a light sensing assembly using a light guiding arrangement, wherein the light guiding arrangement comprises a mirror in which is defined a plurality of apertures, allowing passage of the multi-beam through the mirror towards the sample; and
splitting the light generated into a plurality of light beams desirably using a beam splitter, preferably for an assessment sensor and a detector; and
detecting the generated light, desirably using the assessment sensor and the detector.

### BRIEF DESCRIPTION OF FIGURES

The above and other aspects of the present disclosure will become more apparent from the description of exemplary embodiments, taken in conjunction with the accompanying drawings.
**FIG.** 1 is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of exemplary multi-beam apparatus according to an embodiment.
**FIG. 4** is a schematic cross-sectional view of an objective lens of an inspection apparatus according to an embodiment.
**FIG. 5** is a bottom view of the objective lens of **FIG. 4****.**
**FIG. 6** is a bottom view of a modification of the objective lens of **FIG. 4****.**
**FIG. 7** is an enlarged schematic cross-sectional view of a detector incorporated in the objective lens of **FIG. 4****.**
**FIG. 8** is a schematic diagram illustrating a portion of an electron-optical device comprising a plurality of converters and a light guiding arrangement.
**FIG. 9** is a schematic diagram illustrating example positions for the converters.
**FIG. 10** is a schematic diagram of exemplary multi-beam apparatus according to an embodiment.
**FIG. 11** is a schematic diagram of exemplary multi-beam apparatus according to an embodiment.
**FIG. 12** is a schematic diagram of exemplary multi-beam apparatus according to an embodiment.
**FIG. 13** is a schematic diagram of exemplary multi-beam apparatus according to an embodiment.
**FIG. 14** is a schematic diagram of exemplary multi-beam apparatus according to an embodiment.
**FIG. 15** is a schematic diagram of exemplary multi-beam apparatus according to an embodiment.
**FIG. 16** is a schematic diagram of exemplary multi-beam apparatus according to an embodiment.
**FIG. 17** is a schematic diagram of exemplary multi-beam apparatus according to an embodiment.
**FIG. 18** is a schematic diagram illustrating a portion of an electron-optical device comprising a plurality of converters and a light guiding arrangement.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection apparatuses (such as a Scanning Electron Microscope ('SEM')) is essential for maintaining high yield and low cost.

A SEM comprises a scanner system and a detector system. The scanner system comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detector system captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam SEM.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

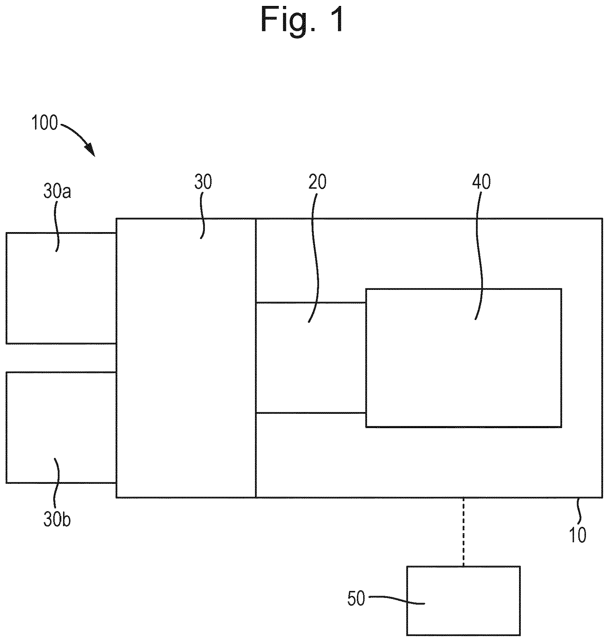

Reference is now made to **FIG. 1****,** which is a schematic diagram illustrating an exemplary charged particle beam inspection apparatus 100. The charged particle beam inspection apparatus 100 of **FIG. 1** includes a main chamber 10, a load lock chamber 20, an electron optical apparatus 40, an equipment front end module (EFEM) 30 and a controller 50. The electron optical apparatus 40 is located within main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron optical apparatus by which it may be inspected. An electron optical apparatus 40 may be a multi-beam electron optical apparatus.

The controller 50 is electronically connected to electron optical apparatus 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron optical apparatus, it should be noted that aspects of the disclosure in their broadest sense are not limited to a chamber housing an electron optical apparatus. Rather, it is appreciated that the foregoing principles may also be applied to other tools and other arrangements of apparatus, that operate under the second pressure.

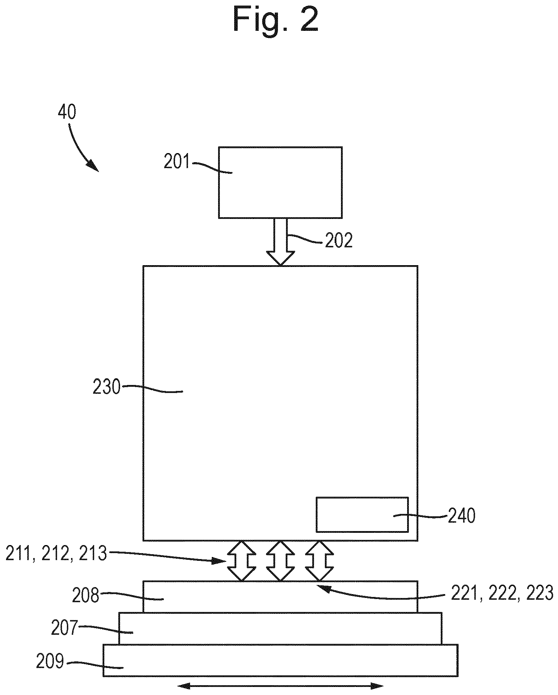

Reference is now made to **FIG. 2****,** which is a schematic diagram illustrating an exemplary multi-beam electron optical apparatus 40 that is part of the exemplary charged particle beam inspection apparatus 100 of **FIG. 1****.** The multi-beam electron optical apparatus 40 (also referred to herein as apparatus 40) comprises an electron source 201, a projection apparatus 230, a motorized stage 209, and a sample holder 207. The electron source 201 and the projection apparatus 230 may together be referred to as an illumination apparatus. The sample holder 207 is supported by the motorized stage 209 so as to hold a sample 208 (e.g., a substrate or a mask) for inspection. The multibeam electron optical apparatus 40 further comprises an electron detection device 240.

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a source beam (or primary electron beam) 202.

The projection apparatus 230 is configured to convert the source beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam inspection apparatus 100 of **FIG. 1****,** such as the electron source 201, the electron detection device 240, the projection apparatus 230, and the motorized stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus the sub-beams 211, 212, and 213 onto a sample 208 for inspection and may form three probe spots 221, 222, and 223 on the surface of the sample 208. The projection apparatus 230 may be configured to deflect the primary sub-beams 211, 212, and 213 to scan the probe spots 221, 222, and 223 across individual scanning areas in a section of the surface of sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV and backscattered electrons typically have electron energy between 50 eV and the landing energy of the primary sub-beams 211, 212, and 213.

The electron detection device 240 is configured to detect secondary electrons and/or backscattered electrons and to generate corresponding signals which are sent to the controller 50 or a signal processing system (not shown), e.g. to construct images of the corresponding scanned areas of the sample 208. Desirably, the electron detection device is incorporated into the projection apparatus. Alternatively it may be separate therefrom, with a secondary electron-optical column (or device) being provided to direct secondary electrons and/or backscattered electrons to the electron detection device.

The controller 50 may comprise an image processing system that includes an image acquirer (not shown) and a storage device (not shown). For example, the controller may comprise a processor, a computer, a server, a mainframe host, terminals, a personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. The acquired images may comprise multiple images of a single imaging area of the sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of the primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move the sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

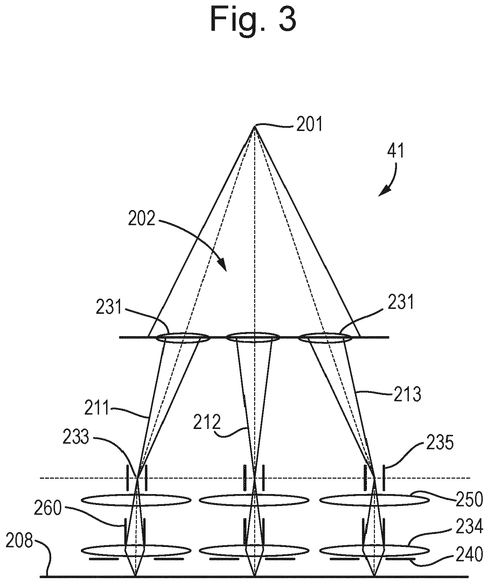

**FIG. 3** is a schematic diagram of an assessment apparatus comprising an electron source 201 and an electron optical device (or electron optical column). (In another arrangement the source is part of the electron-optical device). The electron optical device comprises a plurality of electron optical elements. An electron optical element is any element that affects (e.g. directs, shapes or focuses) an electron beam and may use electric and/or magnetic fields. The electron source 201 directs electrons toward an array of condenser lenses 231 forming part of the electron optical device. The electron source is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array therefore functions as a beam divider, beam splitter, beam generator or beam separator. The condenser lens array may take the form of at least two plates, acting as electrodes, with an aperture in each plate aligned with each other and corresponding to the location of a sub-beam. At least two of the plates are maintained during operation at different potentials to achieve the desired lensing effect. The plates therefore have an array of apertures, each aperture corresponding to the path of a sub-beam. The plate positioned most upbeam is an aperture array configured to function as the beam separator and may referred to as a beam limiting aperture. In a different arrangement the beam separator may be part of or associated with the condenser lens array, with a separate function from lensing the sub-beams. Between the plates of the condenser lens array are electrically insulating plates for example made of an insulating material such as ceramic or glass, with one or more apertures for the sub-beams.

In an arrangement the condenser lens array is formed of three plate arrays in which charged particles have the same energy as they enter and leave each lens, which arrangement may be referred to as an Einzel lens. The beam energy is the same on entering as leaving the Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. The sub-beams diverge with respect to each other. At the intermediate focuses 233 are deflectors 235. The deflectors 235 are positioned in the beamlet paths at, or at least around, the position of the corresponding intermediate focusses 233 or focus points (i.e. points of focus). The deflectors are positioned in the beamlet paths at the intermediate image plane of the associated beamlet, i.e. at its focus or focus point. The deflectors 235 are configured to operate on the respective beamlets 211, 212, 213. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the beamlets so that upbeam of the deflectors, the beamlet paths with respect to each other are diverging. Downbeam of the deflectors the beamlet paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array.

Below (i.e. downbeam or further from the source 201) deflectors 235 there is a control lens array 250 comprising a control lens 251 for each sub-beam 211, 21, 213. The control lens array 250 may comprise at least two, for example three, plate electrode arrays connected to respective potential sources. A function of the control lens array 250 is to optimize the beam opening angle with respect to the demagnification of the beam and/or to control the beam energy delivered to objective lenses 234, each of which directs a respective sub-beam 211, 212, 213 onto the sample 208. The control lenses pre-focus the sub-beams (e.g. apply a focusing action to the sub-beams prior to the sub-beams reaching the objective lenses 234). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. Note that the reference to demagnification and opening angle is intended to refer to variation of the same parameter. In an ideal arrangement the product of demagnification and the corresponding opening angle is constant over a range of values.

The objective lenses 234 are arranged in an objective lens array. The objective lenses 234 can be configured to demagnify the electron beam by a factor greater than 10, desirably in the range of 50 to 100 or more. The objective lenses 234 may be Einzel lenses. At least the chromatic aberrations generated in a beam by a condenser lens and the corresponding downbeam objective lens may mutually cancel.

An electron detection device 240 is provided between the objective lenses 234 and the sample 208 to detect secondary and/or backscattered electrons emitted from the sample 208. An exemplary construction of the electron detection system is described below.

Optionally an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The apparatus of **FIG. 3** can be configured to control the landing energy of the electrons on the sample. The landing energy can be selected to increase emission and detection of secondary electrons dependent on the nature of the sample being assessed. A controller provided to control the objective lenses 234 may be configured to control the landing energy by varying the potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. A controller may be configured to control the landing energy to any desired value within a predetermined range or to a desired one of a plurality of predetermined values. In an embodiment, the landing energy can be controlled to desired value in the range of from 1000 eV to 5000 eV.

Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can also be referred to as a refocus lens as it can function to correct the focus position in view of changes in the landing energy. The use of the control lens array enables the objective lens array to be operated at its optimal electric field strength. Details of electrode structures and potentials that can be used to control landing energy are disclosed in EPA 20158804.3, which document is incorporated herein by reference.

The landing energy of the electrons may be controlled in the system of **FIG. 3** because any off-axis aberrations generated in the beamlet path are generated in, or at least mainly in, the condenser lenses 231. The objective lenses 234 of the system shown in **FIG. 3** need not be Einzel lenses. This is because, as the beams are collimated, off-axis aberrations would not be generated in the objective lenses. The off-axis aberrations can be controlled better in the condenser lenses than in the objective lenses 234. By making the condenser lenses 231 substantially thinner the contributions of the condenser lenses to the off-axis aberrations, specifically the chromatic off-axis aberrations, may be minimized. The thickness of the condenser lens 231 may be varied to tune the chromatic off-axis contribution balancing other contributions of the chromatic aberrations in the respective beamlet paths. Thus the objective lenses 234 may have two or more electrodes. The beam energy on entering an objective lens can be different from its energy leaving the objective lens, for example to provide a decelerating objective lens. Further in using two electrodes as few electrodes are used as possible, enabling the lens array to take a smaller volume.

In some embodiments, the electron optical apparatus further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane or focus points) comprise deflectors to correct for the source 201 appearing to be at different positions for different beams. Correctors can be used to correct macroscopic aberrations resulting from the source that prevent a good alignment between each sub-beam and a corresponding objective lens. In some circumstances it is desirable to position the correctors as far upbeam as possible. In this way, a small angular correction can effect a large displacement at the sample so that weaker correctors can be used. Desirably the correctors are positioned to minimize introduction of additional aberrations. Additionally or alternatively other nonuniformities in the source beam may be corrected; that is aberrations in the source beam uniformity may be corrected.

The aberration correctors may correct other aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses 231 are vertically close or coincident with the beam apertures. That is, correction by the corrector of any angular error will require a smaller positional shift than if the corrector is positioned further downbeam. Correcting such aberrations further downbeam such as at the intermediate foci may be impacted by misalignment between the sub-beams 211, 212, 213 and the correctors. A challenge with positioning correctors at or near the condenser lenses 231, however, is that the sub-beams each have relatively large sectional areas and relatively small pitch at this location, relative to locations further downbeam. In situations with volume restrictions, the corrector array or additional corrector arrays may be located away from these preferred locations, such as between the condenser lens array and the intermediate focus positions.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. There may be an aberration corrector of this design for each beamlet, i.e. an individual beamlet corrector. The individual beamlet correctors may be in an array across the multi-beam, which may be referred to as a corrector array.

In an embodiment the objective lens array referred to in earlier embodiments is an array objective lens. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an two electrode decelerating lens. Each electrode may in its own right be considered as a lens; each electrode may be considered an electron-optical element (or electron-optical component). Between the plates (for example electrodes) of the objective lens array are electrically insulating plates for example made of an insulating material such as ceramic or glass, with one or more apertures for the sub-beams

The bottom electrode of the objective lens is a chip detector, such as a CMOS chip detector, integrated into a multi-beam manipulator array. Integration of a detector array into the objective lens replaces a secondary column. The chip is preferably orientated to face the sample (because of the small distance (e.g. 100µm) between sample and bottom of the electron-optical system). In an embodiment, capture electrodes to capture the secondary electron signals are provided. The capture electrodes can be formed in the metal layer of a device on and/or in the chip, for example, a CMOS device. The capture electrode may form the bottom layer of the objective lens. The capture electrode may form the bottom surface in the detector chip, e.g. a CMOS chip. The CMOS chip may be a CMOS chip detector. The chip e.g. the CMOS chip may be integrated into the sample facing surface of an objective lens assembly. The capture electrodes are examples of sensor units for detecting secondary electrons. The capture electrodes can be formed in other layers. Power and control signals of the integrated devices on the chip, e.g. the CMOS, may be connected to the integrated devices by through-silicon vias. For robustness, preferably the bottom electrode consist of two elements: the chip, e.g. the CMOS chip, and a passive Si plate with holes. The plate shields the integrated devices, e.g. the CMOS, from high E-fields.

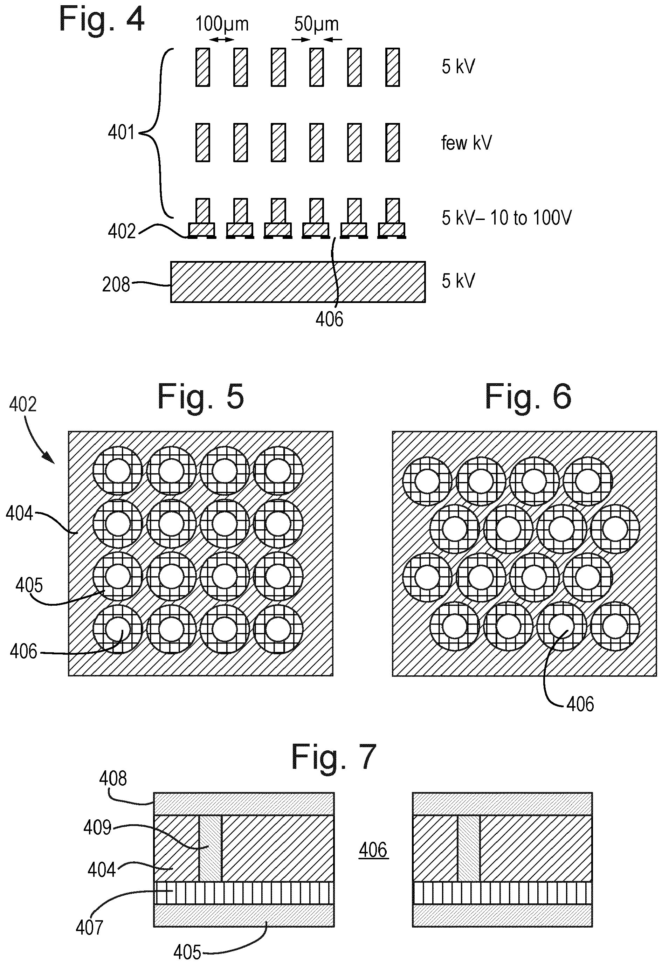

An exemplary embodiment is shown in **FIG. 4** which illustrates a multibeam objective lens 401 in schematic cross section. On the output side of the objective lens 401, the side facing the sample 208, a detector module 402 is provided. The detector module 402 is an example of an electron detection device. **FIG. 5** is a bottom view of detector module 402 which comprises a substrate 404 on which are provided a plurality of capture electrodes 405 each surrounding a beam aperture 406. Beam apertures 406 are large enough not to block any of the primary electron beams. Capture electrodes 405 can be considered as examples of sensor units which receive back-scattered or secondary electrodes and generate a detection signal, in this case an electric current. The beam apertures 406 may be formed by etching through substrate 404. In the arrangement shown in **FIG. 5****,** the beam apertures 406 are shown in a rectangular array. The beam apertures 406 can also be differently arranged, e.g. in a hexagonal close packed array as depicted in **FIG. 6****.**

**FIG. 7** depicts at a larger scale a part of the detector module 402 in cross section. Capture electrodes 405 form the bottommost, i.e. most close to the sample, surface of the detector module 402. In operation, the array of capture electrodes 405 face the sample 208. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallization layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

**FIG. 4** depicts a three-electrode objective lens but it will be appreciated that any other form of objective lens, e.g. a two-electrode lens, may also be used.

In another arrangement the detector array is associated with alternatively or additionally with another electrode of the objective lens array. The detector array may additionally or alternatively be associated with another plate such as electrode such as lens electrode associated with the objective lens integrated in the objective lens array or upbeam of yet proximate to the objective lens such as of the control lens array. In an arrangement additionally or alternatively the detector array is located upbeam of the objective lens array and any electron-optical element associated with the objective lens. The detector elements of the detector array may be associated with respective sub-beams. The detector elements may comprise charge detecting, scintillators and PIN detecting elements. In arrangement in which the detector elements comprise scintillators, the detectors may be set to one side of the sub-beam paths so that the sub-beams pass to the side of respective detector elements.

A deflecting element may be between the detector array and the objective lens, such as a Wien filter e.g. a Wien filter array. Such a Wien filter permits sub-beams to pass through the Wien filter towards the sample undeflected but directs signal particles from the sample towards the detector elements. Optical converters, e.g. optical detectors, may be positioned to convert light generated by the scintillators into electronic signals., The optical converters may be coplanar and even in direct contact with the scintillating detector elements. Such optical converters are described in EP Application 21183803.2 filed on 5 July 2021, which filing is incorporated by reference at least with respect to the optical converters associated with the scintillating detectors and the architecture and use of detectors for detecting signal particles.

In an alternative embodiment the condenser lens array may not be provided. Instead the sub-beams 211, 212, 213 may be generated from the source beam at the objective lens array or at associated plates (for example electrodes) associated with the objective lens array, upbeam of the objective lens array and proximate to the objective lens array. The control lens array may be an example of such an associated plate. Between adjoining plates are electrically insulating plates for example made of an insulating material such as ceramic or glass, with one or more apertures for the sub-beams The objective lens array may feature an upper beam limiter and a beam shaping limiter. In such an arrangement the source 201 provides a beam of charged particles (e.g. electrons). Sub-beams may be derived from the beam, for example, using a beam limiter defining an array of beam-limiting apertures, e.g. the upper beam limiter. The upper beam limiter defines an array of beam-limiting apertures and functions as a beam separator or sub-beam generator. The upper beam limiter may be located upbeam of the deflectors 235 for example in an array for example with a deflector for each sub-beam. Downbeam of the upper beam limiter is a beam shaping limiter. Another electron optical element such as the objective lens array is between the upper beam limiter and the beam shaping limiter, The beam shaping limiter may be more proximate a surface of the electron-optical device that faces the sample during operation than the objective lens array.

In some embodiments, exemplified in **FIG. 3****,** the deflectors 235 are the first deflecting or focusing electron-optical array element in the beam path down-beam of the source 201. In another arrangement, a macro-collimator may be provided upbeam of the objective lens array. Thus the macro-collimator operates on the beam from the source before generation of the multi-beam. A magnetic lens may be used as the macro-collimator. When a macro-collimator is provided, the collimator deflectors 235, for example downbeam of the upper beam limiter, may be omitted.

In another arrangement, a macro scan deflector may be provided upbeam of the objective lens array. Thus the macro scan deflector operates on the beam from the source before generation of the multi-beam. The macro scan deflector may be downbeam of a macro-collimator. When a macro scan deflector is provided, the scan deflector array 260 may be omitted.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

As described above, multiple electron-optical components in an electron optical column (such as a multibeam SEM or multibeam lithographic machine) are typically required to create a plurality of beams. The electron-optical components form electron optical apertures, lenses, deflectors and perform other manipulations of the beams. These electron optical components may include arrays of electron-optical elements (one or more which may be in the form of MEMS elements) and need to be aligned accurately to allow all beams to land on a target (for example a sample or a detector). The electron-optical components, such as electron-optical arrays, which are in close proximity to each other can be stacked on top of each other and are alignable. Some techniques of aligning the electron optical components include corrector components such as corrector arrays in the electron-optical device, for example as described herein. Such components may operable to achieve improved alignment. One such electron optical component is a collimator which may have the functions of aligning and collimating. Additionally or alternatively, other correctors for example upbeam of a beam limiting aperture array so that the corrector operates on the source beam, present in and associated with the condenser lens (e.g. the condenser lens array) such as proximally downbeam of the condenser lens , the collimator (for example associated with the intermediate focus 233, and the objective lens array.

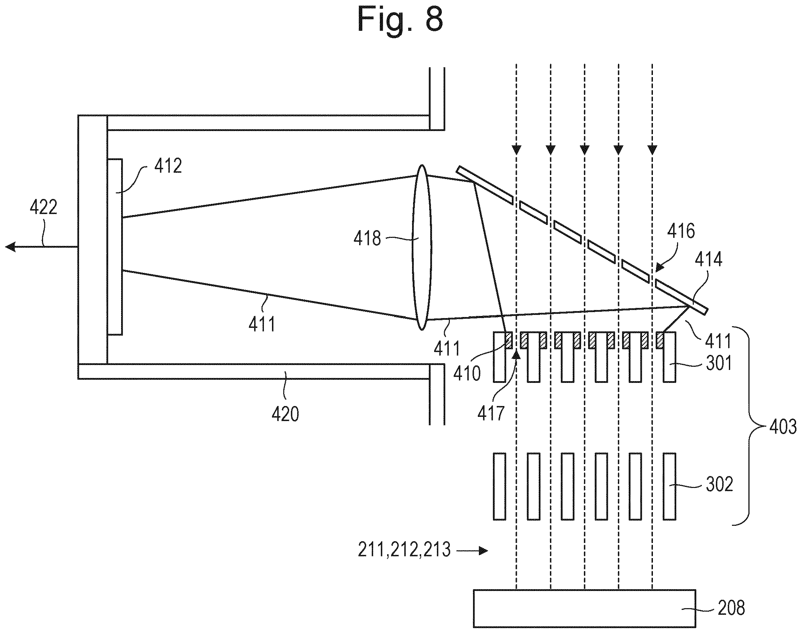

**FIG. 8** schematically depicts a scintillator-based detector approach that facilitates close packing of beams at the sample 208. For ease of depiction, **FIG. 8** depicts only a portion of an example electron optical device in the vicinity of an objective lens array 403 of the electron optical device and the sample 208. The objective lens array 403 depicted has two plates or electrodes 301, 302, This is the minimum number of plates for a practical objective lens array. However there may be as many plates as the designer may be chosen for example three, four, five, seven or ten or more. Each plate may provide an additional degree of freedom with which to control the array of sub-beams, In an arrangement two or more plates may be operated as the objective lens and the remaining plates proximate to the plates selected as the objective lens, may be associated plates associated with the objective lens array and may be designated a different name such as a control lens array.

The electron optical apparatus may comprise an aperture array (to form the sub-beams of the multi-beam from the source beam) and a collimator upbeam of the region of the electron optical device shown in **FIG. 8****.** The aperture array generates a plurality of beams. The collimator collimates paths of the beams. The detector in this example comprises a plurality of converters 410 and a light sensor 412. The converters 410 may be scintillators. The plurality of converters 410 may be referred to as a converter array. Broken line paths depict representative paths of the beams. The converters 410 receive signal particles emitted from the sample 208. The converters 410 generate light 411 in response to the received signal particles. The converters 410 may comprise luminescent material that absorbs energy from incoming particles and re-emits the absorbed energy as light. The light sensor 412 detects light 411 generated by the converters 410 and thereby indirectly detects the signal particles.

A light guiding arrangement is provided that reduces or avoids the need for optical fibers. The light guiding arrangement guides light 411 generated by the converters 410 to the light sensor 412. The light guiding arrangement comprises a mirror 414. Light 411 generated by the converters 410 is reflected by the mirror 414 towards the light sensor 412. (Thus, the mirror is an embodiment of a radiation reflective surface that is reflective of radiation having a wavelength corresponding to the scintillators). Optics 418 may be provided for controlling propagation of reflected light between the mirror 414 and the light sensor 412. The optics 418 may, for example, image the reflected light onto the light sensor 412. The arrangement allows the light sensor 412 to be positioned outside of the part of the column through which the beams pass (i.e. away from the beam arrangement), as indicated schematically in **FIG. 8** by the laterally protruding housing 420. The light sensor may be remote from the electro-magnetic fields of the electron-optical components. Electron-magnetic interference of the light sensor and the electron-optical components by each other can be reduced if not prevented. The light sensor 412 may thus be provided at a radially distal position relative to the path of the beams. For example, a separation between a central longitudinal axis of the plurality of beams and a radially outermost one of the beams is smaller than a distance from the longitudinal axis to the light sensor 412. The light sensor 412 does not therefore restrict close packing of the beams. The light sensor 412 can furthermore be implemented easily because there are fewer space restrictions at the location of the light sensor 412 than there are closer to the longitudinal axis. Furthermore, the mirror redirects light without requiring optical fibers or the like, thereby further reducing restrictions to close packing of the beams. The light sensor 412 can be provided within a vacuum region or outside of a vacuum region e.g. with a window or other arrangement being provided to transport light from the mirror 414 (in a vacuum region) to the light sensor 412 (outside of the vacuum region).

The light sensor 412 may be implemented using any of various known devices for detecting light, such as a charge-coupled device (CCD) for example. In some arrangements, the light sensor 412 comprises a photodiode array. The light sensor 412 may be configured or selected to have a wavelength sensitivity matched to the scintillator spectrum (i.e. the wavelength spectrum of the photons emitted by the scintillator element). Appropriate data lines 422, of various known arrangements, may be provided for extracting data representing the detected light.

In some arrangements, the light guiding arrangement comprises one or more optical fibers between the mirror 414 and the light sensor 412. The optical fibers collect light from the mirror and guide the light to a location further away from the part of the column through which the beams pass, for example away from the path of the beam arrangement. Using optical fibers in this way provides further flexibility for positioning of the light sensor 412 (and associated electronics and/or data lines). The light sensor 412 can be positioned more remotely from the column. The light sensor 412 can be positioned out of the direct line of sight of the mirror 412,

In some arrangements, at least part of the light guiding arrangement and the objective lens array are structurally connected. A support for the mirror 414 may be structurally connected to and/or support at least a most proximate electrode of the objective lens array 403. For example, the support for the mirror 414 may be structurally connected to a support of the most proximate electrode. In a different arrangement the mirror has an independent and separate structural support.

To allow the plurality of beams to pass through the mirror 414, the mirror 414 is configured to define a plurality of apertures 416 through the mirror 414. The apertures 416 are positioned to allow passage of the plurality of beams through the mirror 414 towards the sample 208. Each aperture 416 may thus correspond to a respective one or more of the beams (i.e., be positioned to allow the respective one or more beams to pass through it).

In some arrangements, the converters 410 are each configured to receive signal particles originating from interaction between the sample 208 and a respective single one of the plurality of beams from the aperture array 401. Thus, for one position of the column relative to the sample 208, each converter 410 receives signal particles from a different portion of the sample 208.

In some arrangements, the converters are arranged in an array. The array is orthogonal to the path of the plurality of beams (i.e., substantially orthogonal to each of the paths). The array may comprise a two-dimensional pattern. The two-dimensional pattern may take the form of a grid. The arrangement may be a hexagonal or rectilinear grid. The array of converters may correspond geometrically to the array of beams 211, 212, 213. The converters may take the form of an annulus around an aperture for the path of a corresponding primary beam (or more than one primary beam). Thus, an aperture may be defined by each scintillator. Each converter element in the array of converters may have the form of an annulus.

In an arrangement, the converters 410 are positioned up-beam of at least one electrode 302 of the objective lens array 403, or associated with the objective lens array. The converters 410 may be positioned upbeam of an electrode 302 facing the sample 208. In some arrangements, as exemplified in **FIG. 8****,** the converters 410 are supported by one of the electrodes 301 of the objective lens array 403. In the example shown, the converters 410 are supported by an electrode 301 of the objective lens array 403 that is furthest from the sample 208. The converters 410 are at the same level as an uppermost portion (furthest from the sample 208) of the electrode 301. In an embodiment the converters 410 are supported by the most up-beam electrode associated with the objective lens array. In some arrangements, the scintillators 410 are positioned up-beam of the objective lens array 403 (or even of the most upbeam electrode associated with the objective lens array), for example directly upbeam thereof (e.g., a small distance therefrom and/or with no intervening elements between the converters 410 and the objective lens array 403, or the most upbeam electrode associated with the objective lens array 403).

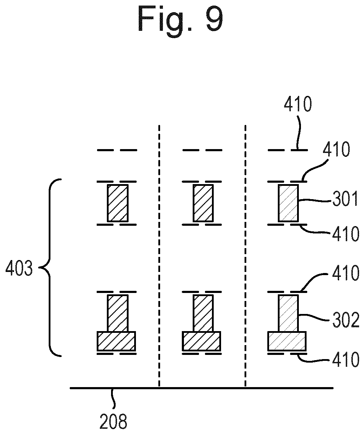

**FIG. 9** shows further example locations for the converters 410 relative to a portion of an example objective lens array 403. Although two electrodes 301, 302 are depicted, the locations for the converters may be applied to the electrodes of an objective lens array with any number of electrodes and any number of electrodes that may be associated with the objective lens array so as to be proximate to the objective lens array. Vertical broken lines depict paths of two example beams through respective objective lenses of the objective lens array 403. Five example locations for the converters 410 are shown. The converters 410 may be provided at a single one of these five locations or at more than one location. Some of the locations are more favorable than others. The less favorable locations may be used in combination with other locations to capture sufficient signal. The converters 410 may be provided below an electrode 302 of the objective lens array 403 that is closest to the sample 208 (e.g. facing the sample 208). The converters 410 may be positioned above the electrode 302 closest to the sample 208 and below an electrode 301 adjacent to the electrode 302 closest to the sample 208. In this case, the converters 410 may be closer to, and/or attached to, the electrode 302 closest to the sample 208. Alternatively, the converter 410 may be closer to, and/or attached to, the adjacent electrode 301. Alternatively, the converter 410 may be positioned above the adjacent electrode 301, either directly adjacent and/or attached to the adjacent electrode 301 or separated from the adjacent electrode 301 and/or positioned further away.

In an arrangement, each converter 410 surrounds an aperture 417 configured to allow passage of a respective one of the plurality of beams. The aperture 417 may be defined in an electrode of the objective lens or in a separate aperture body. Each converter in this arrangement is around the path of a respective beam. Each converter 410 may be positioned to receive signal electrons propagating generally along the path of the beam in an opposite direction to the beam. The signal electrons may thus impinge on the converter 410 in an annular region. Signal electrons do not impinge on the center region of the annulus because of the aperture for allowing passage of the corresponding primary beam in the opposite direction.

In some arrangements, each converter 410 comprises multiple portions. The different portions may be referred to as different zones. Such a converter 410 may be referred to as a zoned converter. The portions of a converter may surround the aperture defined in the converter. Signal particles captured by the converter portions may be combined into a single signal or used to generate independent signals.

The zoned converter 410 may be associated with one of the beams 211, 212, 213. Thus, the multiple portions of one converter 410 may be configured to detect signal particles emitted from the sample 208 in relation to one of the beams 211, 212, 213. The converter comprising multiple portions may be associated with one of the apertures in at least one of the electrodes of the objective lens array 403. More specifically, the converter 410 comprising multiple portions may be arranged around a single aperture.

The portions of the zoned converter may be separated in a variety of different ways, e.g. radially, annularly, or in any other appropriate way. Preferably the portions are of similar angular size and/or similar area and/or similar shape. The separated portions may be provided as a plurality of segments, a plurality of annular portions (e.g. a plurality of concentric annuli or rings), and/or a plurality of sector portions (i.e. radial portions or sectors). The converter 410 may be divided radially. For example, the converter 410 may be provided as annular portions comprising 2, 3, 4, or more portions. More specifically, the converter 410 may comprise an inner annular portion surrounding an aperture and an outer annular portion, radially outwards of the inner annular portion. Alternatively, the converter 410 may be divided angularly. For example, the scintillator 410 may be provided as sector portions comprising 2, 3, 4, or more portions, for example 8, 12 etc. If the converter 410 is provided as two sectors, each sector portion may be a semi-circle. If the converter 410 is provided as four sectors, each sector portion may be a quadrant. In an example, the converter 410 is divided into quadrants, i.e., four sector portions. Alternatively, the converter 410 may be provided with at least one segment portion.

Providing multiple portions concentrically or otherwise may be beneficial because different portions of the converter 410 may be used to detect different signal particles, which may be smaller angle signal particles and/or larger angle signal particles, or secondary signal particles and/or backscatter signal particles. Such a configuration of different signal particles may suit a concentrically zoned converter 410. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features. Note the arrangement of FIG. 8 may have limited ability to detect backscatter signal particles for example, the arrangement may be limited to detect backscatter signal particles with a small-angle backscatter particles. That is, the backscatter signal particles that are detectable using this arrangement are limited by the relatively large distance between the sample 208 and the converter 401 and the relatively narrow paths from the sample 208 to respective converters 401 (for example because the respective apertures through the electrode 302). In such an arrangement the converter is unlikely to have concentric portions because of the low angular range of backscatter signal particles that such a converter is capable of detecting.

The converters 410 may be provided as converter elements each associated with one or more beams of the plurality of beams. Alternatively or additionally, the converters 410 may be provided as a monolithic converter in which a plurality of apertures are defined, each aperture corresponding to a respective one or more beams of the plurality of beams. In some arrangements, the converters are arranged in an array of strips. Each strip may correspond to a group of primary beams. The beams may comprise a plurality of rows of beams and each group may correspond to a respective row.

The description with respect to FIG. 9 may equally apply to other types of detector element, such as charge detector elements and semiconductor element such as PIN detector elements.

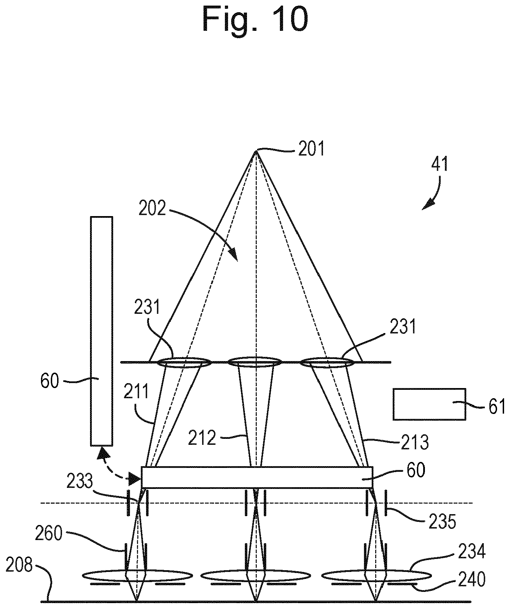

**FIG. 10** is a schematic diagram of exemplary multi-beam electron optical apparatus according to an embodiment. The electron optical apparatus is configured to project a multi-beam of electrons. The electron optical apparatus comprises an electron device (also known as an electron optical device or an electron optical column). The electron optical apparatus may be arranged as described in any of the embodiments described above. The arrangement shown in **FIG. 10** is similar to the arrangement shown in **FIG. 3****,** albeit without the control lens array 250. In an embodiment the electron optical apparatus shown in **FIG. 10** comprises a control lens array as described above (or any number of other associated plates of the objective lens array). In other embodiments, the electron optical apparatus is similar to another of the arrangements described above such as an arrangement comprising a macro collimator and a macro scan deflector instead of the collimator deflectors 235 and the scan deflector array 260. In other embodiments, the electron optical apparatus is similar to another of the arrangements described above such as an arrangement shown in **FIG. 8****.**

In an embodiment the electron device is switchable between (i) an operational configuration in which the device is configured to project the multi-beam to a sample 208 along an operational beam path and (ii) a monitoring configuration in which the device is configured to project the multibeam to a detector (or monitoring detecting system) along a monitoring beam path. The operational beam path extends from a source 201 of the multi-beam to the sample 208. The monitoring beam path extends from the source 201 to the detector. The operational configuration may be for performing an inspection of a sample 208 or for performing metrology, for example. In the operational configuration, signal electrons emitted from the sample may be detected as described above. In the operational configuration, the detector array 240 is used to detect signal particles in the operation configuration. In an embodiment in the monitoring configuration, the multi-beam from the source 201 is monitored, for example using the monitoring detecting system.

As shown in **FIG. 10****,** in an embodiment the monitoring beam path diverts from the inspection beam path part way along the operational beam path. The sample 208 may be separate from the monitoring beam path. In the monitoring configuration, the multi-beam is intercepted upbeam of the sample 208. The multi-beam signal is monitored directly, without interaction with the sample 208; that is the sub-beams of the multi-beam are monitored directly. The monitoring is of primary beams, i.e. the sub-beams, (which may be referred to as a primary signal) rather than signal particles from the sample 208, which may be referred to as secondary signals.

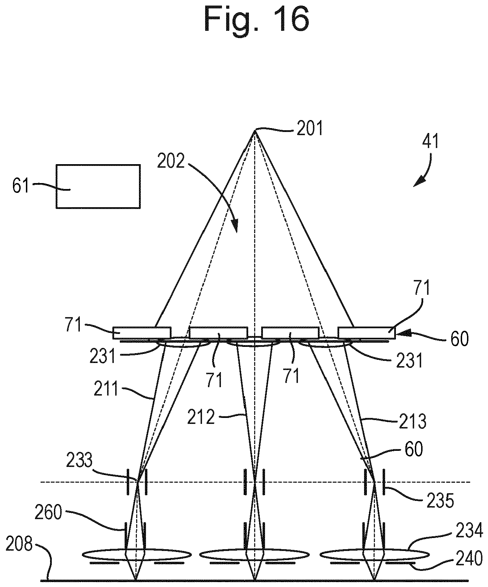

In an embodiment at least one parameter of at least part of the multi-beam is monitored. As shown in **FIG. 10****,** in an embodiment the sub-beams 211, 212, 213 of the multi-beam are monitored. Alternatively, the source beam 202 of the multi-beam may be monitored (for example as described below with reference to **FIGs. 16-17****).** In an embodiment the uniformity of the multi-beam is monitored. The uniformity of the multi-beam may be a measure of the variation of a characteristic across the multi-beam. The characteristic may be intensity or focus, for example. Additionally or alternatively, one or more aberrations of the multi-beam may be monitored. For example, field curvature, distortion and astigmatism may be monitored. Additionally or alternatively, alignment of the multi-beam may be monitored. For example, alignment of the sub-beams 211, 212, 213 with one or more sets of apertures (e.g. apertures in the objective lens assembly or the mirror) may be monitored. Additionally or alternatively, the focus of the multi-beam may be monitored. By monitoring at least one parameter of at least part of the multi-beam, the monitoring may be used to correct and/or mitigate deviations from the nominal values.

Merely as one example, in an embodiment the source current uniformity may be measured by measuring the beam intensity of the individual beamlets 211, 212, 213 outside the MEMS elements (i.e. outside of the condenser lens array and the objective lens array). An adjustment may subsequently be made so as to improve the uniformity of the multi-beam or to compensate for the known lack of uniformity of the multi-beam.

As shown in **FIG. 10****,** in an embodiment the device comprises at least one moveable component. The moveable component is configured to move between an operational position and a monitoring position. The operation position corresponds to the operational configuration. The monitoring position corresponds to the monitoring position. The movement is shown by the double ended dashed arrow in **FIG. 10****.**

In the arrangement shown in **FIG. 10****,** the moveable component comprises a converter 60. Associated with the converter is an optical detector. Together the converter 60 and the optical detector is a monitoring detecting system. The optical detector is external to the converter and is positioned so as to detect light generated by the converter 60. The converter 60 is configured to move between its operational position corresponding to the operational configuration and its monitoring position corresponding to the monitoring configuration. The operational position is shown above the double ended arrow. In the operational position, the converter 60 is positioned lateral to the multibeam, for example the multi-beam device (or column). The converter 60 is positioned to a side of, or adjoining, the multi-beam . The multi-beam passes beside the converter 60 without interacting with the converter 60. The multi-beam is projected to the sample 208. In **FIG. 10****,** the moveable component has a different orientation in the operational position compared to in the monitoring position. In particular in the monitoring position, the converter 60 is substantially perpendicular to the direction of the multi-beam. The converter 60 may be planar. In the operational position, the converter 60 may be non-perpendicular to the multi-beam. For example, the converter 60 may be oriented such that a normal to its surface is perpendicular to the multi-beam. By changing the orientation between the operational position and the monitoring position, an embodiment of the invention is expected to reduce or minimize the volume taken up by the converter 60. In an alternative arrangement, the orientation of the moveable component may be the same for the operational position and the monitoring position. For example, the moveable component may be moved perpendicularly to the multi-beam so as to perform the movement, without tilting the moveable component. For example the moveable component may be slid between the operational and monitoring position. Such operation may benefit from a simple arrangement to actuate between the two positions. Such sliding may be actuated linearly. The sliding may be actuated rotationally, such as about an axis remote from the paths the sub-beam. A rotational actuation may enable reduction or minimization of the volume taken up by the converter 60 and its actuation.

The monitoring position is shown to the right of the double ended arrow. As shown in **FIG. 10****,** in an embodiment the monitoring position is between the source 201 and the sample 208. In the monitoring position, the converter 60 intercepts the multi-beam upbeam of the sample 208. The converter 60 is configured to receive the multi-beam output by the source 201 and to generate light in response to the received multi-beam. Although the converter 60 is depicted just upbeam of the intermediate focus points, the converter can be positioned in a monitoring position at an position along the sub-beam path from upbeam of a beam limiting aperture array of or associated with the condenser lens array to upbeam of the objective lens array, for example: at any position between the condenser lens array to the intermediate focus, between the intermediate focus and the objective lens array for example downbeam of one or more electrodes associated with but upbeam of the objective lens array. Note, if the converter 60 is upbeam of the beam limiting aperture array, then the converter would intercept the source beam rather than a plurality of sub-beams.

In an embodiment the converter 60 comprises a scintillator. The converter 60 may comprise a conversion material such as YAG. The conversion material may comprise, for example a pure crystalline material Y₃Al₅O₁₂, which may be doped with cerium to form YAG:Ce. The converter 60 may be formed as a YAG screen. In an arrangement the converter comprises a single scintillator. In another arrangement, the converter comprises a scintillator for one or more sub-beams of the multibean. In an arrangement, the converter comprises a plurality of elements for each sub-beam. The scintillator elements may be comprised in an array, for example a two dimensional array, for example corresponding to the array of sub-beams of the multi-beam.

As shown in **FIG. 10****,** the moveable component may be retractable. The converter 60 may be configured to convert the multi-beam into light. Light is generated by the individual electron beamlets 211, 212, 213 and can be read out by an optical detector, e.g. an external camera 61. The optical detector is remote from the converter. The optical detector is position so it can detect light emitted by the converter 60. The optical detector is in the line of sight of at least the position of the converter 60 that generates light in response to electrons. In an embodiment a measurement of individual beam profiles may be performed for more detailed information on the source emission properties. Such measurement may be made in the optical detector, electronics associated with the detector, in remote electronics in the electron-optical system such as a remote processing rack, or a processor located somewhere between these two extremes for example in the electron-optical device or electron-optical apparatus.

The converter 60 may be expected to have a long lifetime when interacting with high energy electrons. By providing the converter 60 and the external optical detector such as the camera 61, it is not necessary for additional electronic components to be located inside the vacuum. This can help to simplify the design of the electron optical apparatus.

In an embodiment the at least one moveable component comprises a light guiding arrangement configured to guide the light generated by the converter 60 towards the optical detector. In an embodiment the electron optical device comprises a waveguide configured to guide the light from the converter 60 to the optical detector. This makes it possible to read out the generated light with a fiber in-situ that is coupled to the optical detector ex-situ. The use of optical fibers in this way enables the optical detector to detect the light generated by the converter 60 without the optical detector having to be in the direct line of sight of the converter 60. For example one or more optical fibers may be provided. This could be useful to help reduce the volume required for the converter 60 and the optical detector.

As shown in **FIG. 10****,** in an embodiment the source 201 and the electron optical elements such as the condenser lens array 231 and the objective lens array may remain stationary when the moveable component moves between the operational position and the monitoring position. An embodiment of the invention is expected to maintain alignment of the multi-beam.

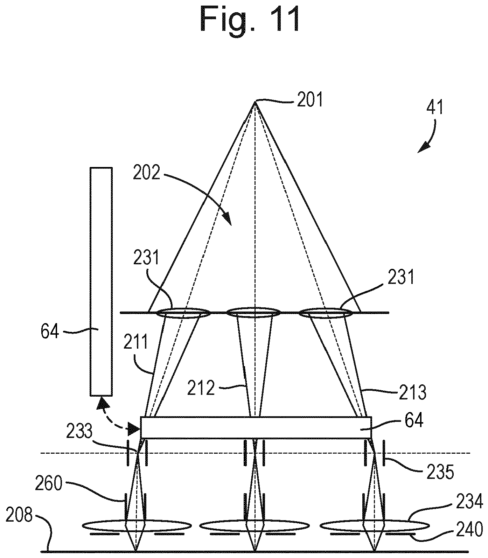

**FIG. 11** is a schematic diagram of exemplary multi-beam electron optical apparatus according to an embodiment. Features of the arrangement that are the same as the arrangement shown in **FIG. 10** are not repeated below. Such common features may take the same reference numbers and description unless otherwise mentioned. As shown in **FIG. 11****,** in an embodiment the at least one moveable component comprises a monitoring detector 64 (or monitoring detecting system). That is the monitoring detecting system is the monitoring detector 64. Accordingly it is not necessary to provide any external optical detector, for example the camera 61.

In an embodiment the monitoring detector 64 comprises a charge detector such as a Faraday cup array. Optionally each charged detector such as a Faraday cup is configured to measure a respective beamlet. In an alternative embodiment the monitoring detector 64 comprises a charge-coupled device (CCD). Optionally the monitoring detector may be a semiconductor based detector such as a PIN detector. In an alternative embodiment the monitoring detector 64 comprises a direct light detector device comprising a converter configured to generate light in response to a charged particle, and an adjoining optical detector. The adjoining optical detector is configured to directly convert the generated optical signal generated by the converter into an electrical signal. The optical detector may be in contact with the converter.

Such a charged detector (such as a Faraday cup array, or CCD) or a PIN detector can detect and read out the electron beam signals directly, without the light conversion step in between. The direct light detector device is configured to monitor the multi-beam without requiring the external camera 61. An embodiment of the invention is expected to enable monitoring of the multi-beam without requiring a view of the converter 60 with an external camera 61 from outside of the vacuum. The direct light detector device may be expected to have a long lifetime.

In an arrangement the monitoring detector 64 comprises a monitoring detector element. In another arrangement, the converter comprises a monitoring detector element for one or more sub-beams of the multi-beam. In an arrangement, the monitoring detector 64 comprises a plurality of elements for each sub-beam. The monitoring detector elements may be comprised in an array, for example a two dimensional array, for example corresponding to the array of sub-beams of the multibeam.

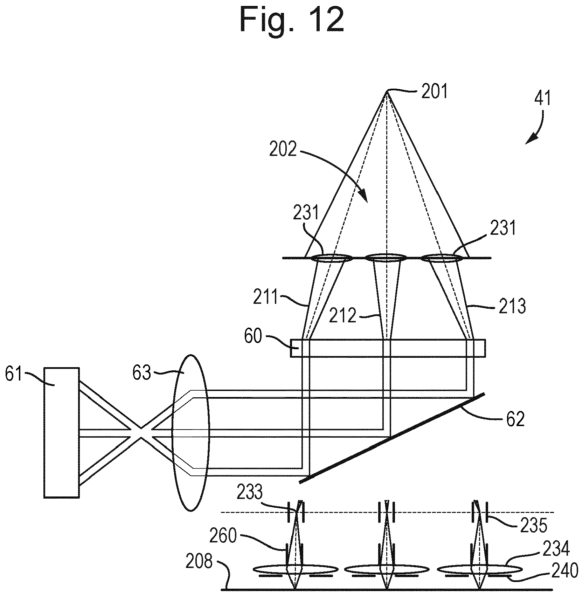

**FIG. 12** is a schematic diagram of exemplary multi-beam electron optical apparatus according to an embodiment. Features of the arrangement that are the same as the arrangement shown in **FIG. 10** are not repeated below. Such common features may take the same reference numbers and description unless otherwise mentioned. As shown in **FIG. 12****,** in an embodiment the moveable component comprises a mirror 62. In a variation the moveable component may be a plurality of separately moveable components or plurality of components that are arranged to be moved together. The plurality of moveable components may together comprise a mirror, for example which may appear as the mirror 62. The mirror 62 is configured in the monitoring position to direct the light generated by the converter 60 towards the optical detector (e.g. external camera 61). Thus the monitoring detecting system may comprise the converter 60, the mirror 62, and the optical detector.

In the monitoring configuration, the mirror 62 may be positioned downbeam of the converter 60. The mirror 62 may be located between the converter 60 and the sample 208. The mirror 62 may be retractable, for example out of the path of the sub-beams. The retraction may be linear and/or rotational for example about an axis spaced away from the paths of the sub-beams. In an embodiment the mirror 62 may be moveable together with the converter 60. The mirror 62 and the converter 60 may have fixed positions relative to each other. Alternatively, the mirror 62 and the converter 60 may be configured to move independently of each other. This may be desirable to reduce the volume required for example by the mirror 62 and converter 60 when they are not in the operational position. The mirror 62 and the converter may have fixed positions relative to each other in the monitoring configuration. The mirror 62 and the converter may have fixed positions relative the position of the path of the sub-beams in the monitoring configuration.

As mentioned above, in an embodiment the moveable component, comprises, or alternatively the moveable components comprise, a light guiding arrangement. The light guiding arrangement is configured to guide the light generated by the converter 60 towards the optical detector. The light guiding arrangement may comprise the mirror 62. In an embodiment the light guiding arrangement may comprise an optical element 63 (e.g. a lens). The optical element 63 is configured to guide the light onto the optical detector that may be external to the electron-optical device (or column) 41 such as the external camera 61. In an embodiment the optical element 63 is moveable between the operational configuration and the monitoring configuration. In an alternative embodiment, the optical element 63 may remain stationary when the moveable component moves. For example, as shown in **FIG. 12****,** in an embodiment the optical element 63 is outside of the operational beam path, for example outside the electron-optical column (or device). It is not necessary for the optical element 63 to move in order for the multi-beam to reach the sample 208. If the optical element and the optical detector are stationary between the operational configuration and the monitoring configuration, volume may be conserved because respective actuators do not need to be provided.

Compared to the arrangement shown in **FIG. 10****,** the mirror 62 and the lens are additional optical components provided so as to aid reading the light signal. That is the mirror 62 and the optical element 63 improve transmission of the light signal from the converter 60 to the optical detector such as the external camera 61. The mirror 62 and the optical element 63 may improve detection and/or collection efficiency.

As shown in **FIG. 12****,** in an embodiment the mirror 62 is tilted relative to the converter 60 for example by an optimal angle. For example the mirror may be tilted between 25 and 65 degrees preferably by about 45 degrees. Tilting the mirror 62 helps to direct the light away from the operational beam path. This allows the optical detector such as the external camera 61 to be positioned externally to the operational beam path such as outside of the vacuum.

In an embodiment the pitch at the sample between beamlets may be of the order of about 70 µm pitch for example between 30 µm to 100 µm. At the sample, a dimension of the footprint of the multi-beam of the sub-beams may be of the order of about 5, 10 or 15 mm. These dimensions may apply to the multi-beam of sub-beams at any point around the point of collimation for example by deflectors 63 or downbeam of collimation of the sub-beams. If the mirror is at 45 degrees, then in an embodiment the mirror 62 is arranged such that its height (i.e. its dimension along the direction of the multi-beam) is about 15 mm. Alternatively or additionally, by controlling the angle of tilt of the mirror 62 for example relative to the direction of the path of the sub-beams (or orthogonal to that direction), the dimension of the mirror in the direction of the multi-beam (i.e. the height dimension in the view shown in the drawings) may be controlled. In the arrangement depicted, the mirror 62 and converter 62 are located upbeam of the intermediate focus point of each sub-beam and the collimator 235. Upbeam of the intermediate focus 233, the paths of the sub-beams diverge and the dimension across the multi-beam (e.g. its width) is smaller.

As shown in **FIG. 12****,** in an embodiment the converter 60, the mirror 62, the optical element 63 and the camera 61 are located downbeam of the condenser lens array 231. In an alternative embodiment the converter 60, the mirror 62, the optical element 63 and the camera 61 are located upbeam of the condenser lens array 231. This may be beneficial because the size of the mirror would be smaller because the cross-section of the beam would smaller because it would have diverged less. If the condenser lens array 231 does not feature a beam limiting aperture array, then the converter 60 and the mirror 62 may be located downbeam of the beam limiting aperture array. The converter 60 may interact with sub-beams. The mirror may be placed between the beam limiting aperture array and the condenser lens array 231. However if the converter is upbeam of the beam limiting aperture array, the converter 60 will interact with electrons of the source beam 60 rather than sub-beams generated from the source beam. Although this may not provide information about the sub-beams, detection of the electrons from the source beam can still provide information about the sub-beams generated from the source beam; the sub-beams take on characteristics of the sub-beam from which they are generated.

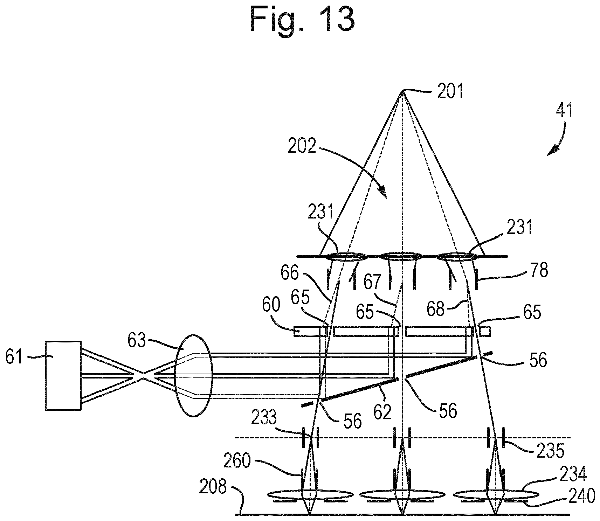

**FIG. 13** is a schematic diagram of exemplary multi-beam electron optical apparatus according to an embodiment. Features of the arrangement that are the same as the arrangement shown in **FIG. 12** are not repeated below. Such common features may take the same reference numbers and description unless otherwise mentioned. As shown in **FIG. 13****,** it is not essential for the mirror 62 and/or the converter 60 to be retractable. In an embodiment the device comprises a converter 60 in the path of the multi-beam to generate light beams in response to the multi-beam and a mirror 62 configured in the monitoring configuration to direct the light beams to the detector, desirably in the monitoring configuration.

The converter 60 may remain in the same position in the operational configuration and in the monitoring position. By having fewer moving parts, reliability may be improved and/or the space taken up by the apparatus may be reduced. An embodiment of the invention is expected to reduce the total volume required by the components used to perform monitoring of the multi-beam.

As shown in **FIG. 13****,** in an embodiment in the converter 60 are defined a plurality of apertures 65 for passage of the paths of the multi-beam. The apertures 65 allow the beamlets to pass through when the electron optical device is in the operational configuration.

As shown in **FIG. 13****,** in an embodiment defined in the mirror 62 is a plurality of openings 56 (or apertures). The openings 56 are configured to allow passage of the sub-beams of the multibeam through the mirror 62 towards the sample 208. The openings 56 allow the beamlets to pass through when the electron optical device is in the operational configuration. The mirror 62 is configured to reflect light towards the optical detector, e.g. the external camera 61. In the operational configuration the paths of the plurality of beams of the multi-beam pass through respective openings 56 defined in the mirror 62.

As shown in **FIG. 13****,** in the monitoring configuration, the paths of the plurality of beams of the multi-beam are incident on the converter 60. The paths of the sub-beams in the operational configuration are different from the paths of the sub-beams in the monitoring configuration. In an embodiment the device comprises a deflector, or a plurality of deflectors operable between an inspection setting corresponding to the operational configuration and a measurement setting corresponding to the monitoring configuration.

For example, as shown in **FIG. 13****,** in an embodiment the electron device comprises a switching deflector array 78. The switching deflector array 78 comprises a plurality of deflectors configured to switch between the operational configuration and the monitoring configuration. Each deflector of the switching deflector array 78 may be configured to act on a respective sub-beam path.

The deflectors of the switching deflector array 78 are configured to control the direction of the sub-beams downbeam of the condenser lens array 231. The switching deflector array may be located downbeam of the condenser lens array 231. The switching deflector array 78 is located upbeam of the converter 60.

In the operational configuration the switching deflector array 78 is configured to direct the sub-beams to pass through the apertures 65 in the converter 60 and the mirror 62. In the monitoring configuration the switching deflector array 78 is configured to direct the sub-beams along switched beam paths 66, 67, 68 to be incident on the converter 60. In an embodiment the controller is configured to control the potentials applied to the electrodes of the switching deflector array 78 so as to control the electron device switching between the operational configuration and the monitoring configuration.

In the arrangement shown in **FIG. 13****,** the switching deflector 78 comprises a plurality of deflector elements to operate on a path of respective beam paths of the multi-beam. In an alternative embodiment the switch deflector 78 comprises a macro deflector is provided configured to operate on all beam paths of the multi-beam. When a macro deflector is provided, the switching deflector array may be omitted. Additionally or alternatively the switching deflector array may have a meso switching deflector for which each deflector is operable on a group of sub-beams of the multibeam.

In a variation of the arrangement depicted and described with reference to **FIG. 13****,** the converter 60 may be replaced with a monitoring detector 64 as described with reference to the embodiment shown in and described with reference to **FIG. 11****.** (That is the monitoring detecting system comprises the monitoring detector 64). For example the monitoring detector may comprise detector elements such as a charged detector (e.g. a Faraday cup or a charged coupled device), a PIN detector and/or a direct light detector device. Having a monitoring detector 64 rather than a converter 60 means the optical elements such as the mirror 62, lens and optical detector 61 are not required. This may reduce the volume required for the monitoring system. Further the apertures 65 and the switching deflector 78 enables the monitoring defector 64 to be maintained in position in the operational configuration as well as in the monitoring configuration.

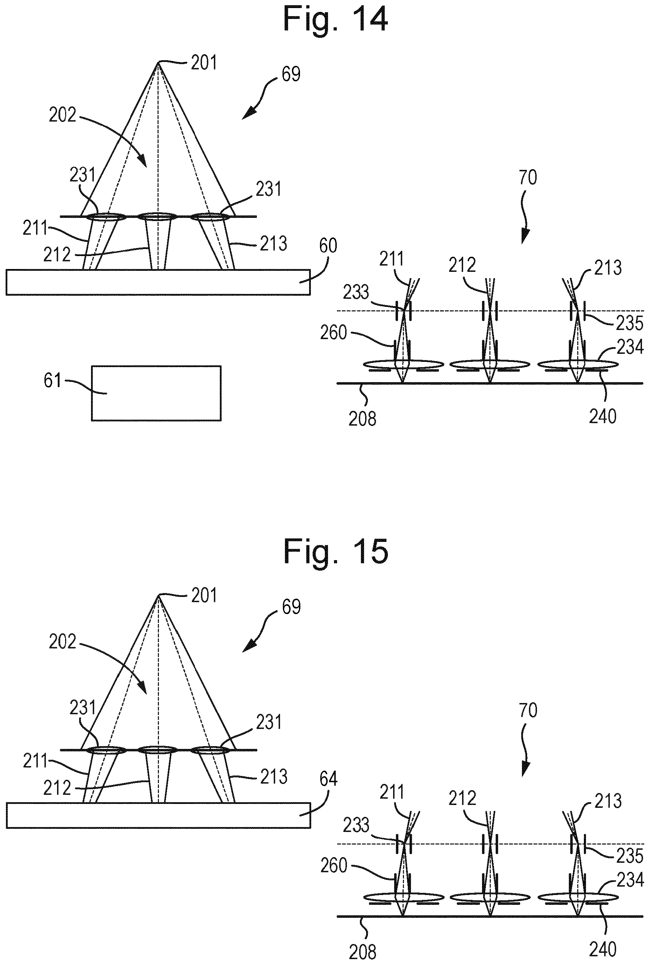

**FIG. 14** is a schematic diagram of exemplary multi-beam electron optical apparatus according to an embodiment. Features of the arrangement that are the same as the arrangement shown in **FIG. 10** are not repeated below. Such common features may take the same reference numbers and description unless otherwise mentioned. As shown in **FIG. 14****,** in an embodiment the at least one moveable component comprises one of the source 201 and an objective lens array. The objective lens array is configured in the operational configuration to project the multi-beam onto the sample 208. **FIG. 14****,** shows the electron device in the monitoring configuration. In the operational configuration, the features of the electron-optical apparatus would appear as in **FIG. 3****,** with the converter 60 and optical detector 61 positioned to the side of the electron device or column 41. Thus the monitoring detecting system comprises the converter 60 and optical detector 61.

The electron device may comprise a source module 69. The source module 69 comprises the source 201. As shown in **FIG. 14****,** in an embodiment the source module 69 comprises the condenser lens array 231. The electron device 41 may further comprise the objective lens array which may be part of a downbeam or objective module 70. The electron device is configured such that the source module 69 and the objective module 70 are moveable relative to each other. In an embodiment the source module 69 is configured to move while the objective module 70 remains stationary, for example between the operational configuration and the monitoring configuration. In an alternative embodiment the objective module 70 is configured to move while the source module 69 remains stationary, for example between the operational configuration and the monitoring configuration. In a further alternative embodiment both the objective module 70 and the source module 69 are configured to move between the operational position and monitoring position of the respective configurations.

As shown in **FIG. 3****,** in an embodiment in the operational configuration the multi-beam is aligned with lenses 234 of the objective lens array 70. As shown in **FIG. 14****,** in an embodiment in the monitoring configuration the multi-beam is offset from the objective lens array 70. In an embodiment the electron optical apparatus comprises an actuator (not shown). The actuator is configured to actuate the electron optical apparatus between the operational configuration and the monitoring configuration. The actuator may be arranged to operate linearly or rotationally around an axis away from the path of the sub-beams, desirably the axis is parallel to the path of the sub-beams.

The source module 69 or the objective module 70 may be configured to move laterally. For example, as shown in **FIG. 14****,** in an embodiment the source module 69 is configured to move laterally such that the multi-beam is aligned with a converter 60 in the monitoring configuration. The converter 60 is configured to convert the electron beams into light. The light may be detected by the optical detector such as a camera 61. Once the monitoring is completed, the source module 69 may be moved so that the multi-beam is aligned with the objective module 70; that is the source module 69 is moved relative to the objective module 70, for example the objective lens array 234. Although the embodiment described with reference to and shown in **FIG. 14** has the source module actuatable, in a different arrangement it is the objective module which is actuatable with the converter 60 so that the converter 60 replaces the objective module 70 downbeam of the source module 69.

When the source module 69 is aligned with the converter, it is easier for the properties of the source 201 to be determined. As shown in **FIG. 14****,** in an embodiment the source module 69 comprises the condenser lens array 231. This may allow the source module 69 to perform a simple lateral movement in order to switch between the monitoring configuration and the operational configuration. Having the condenser lens array 231, or at least the beam limiting aperture array comprised in the source module 69 permits monitoring of the sub-beams and the properties of the sub-beams. Although the division between the source module 69 and objective module 70 is shown upbeam of an intermediate focus of the sub-beams, the division can be at any point downbeam of the condenser lens array 231. For example the division can be downbeam of the collimator array 235, for example downbeam one or more electrodes associated with the objective lens array 234, and for example above the electrodes of the objective lens array.

In an alternative embodiment the source module 69 does not comprise the condenser lens array 231. The condenser lens array may have a fixed position relative to the objective lens array 70. The source 201 is moveable relative to the condenser lens array 231 and the objective lens array 70. In the monitoring configuration, the source beam 202 is incident on the converter 60. This may allow properties of the source to be determined more accurately. For example, any influence of the apertures of the condenser lens array 231 on the measured beam may be avoided. Since the sub-beams are generated by the source beam 202, some properties and characteristics of the source beam would also be present in the sub-beams. Therefore monitoring of the source beam 202 is in effect monitoring of one or more properties of the sub-beams.

**FIG. 15** is a schematic diagram of exemplary multi-beam electron optical apparatus according to an embodiment. Features of the arrangement that are the same as the arrangement shown in **FIG. 14** are not repeated below. Such common features may take the same reference numbers and description unless otherwise mentioned. As shown in **FIG. 15****,** in an embodiment the converter 60 (and optionally the optical detector 61) is replaced by the monitoring detector 64. In this embodiment, the monitoring detecting system comprises the monitoring detector 64.

In an embodiment the monitoring detector 64 comprises a charge detector such as a Faraday cup array. Optionally each Faraday cup is configured to measure a respective beamlet. In an alternative embodiment the monitoring detector 64 comprises a charge detector such as a charge-coupled device (CCD). In an alternative embodiment the monitoring detector 64 comprises a direct light detector device comprising a converter configured to generate light in response to a charged particle, and an adjoining optical detector configured to directly convert the generated optical signal generated by the converter into an electrical signal. The optical detector may be in contact, e.g. direct contact, with the converter.

**FIG. 16** is a schematic diagram of exemplary multi-beam electron optical apparatus according to an embodiment. The electron optical apparatus is configured to project a multi-beam of electrons. The electron optical apparatus may be arranged as described in any of the embodiments described above. Such common features may take the same reference numbers and description unless otherwise mentioned. The arrangement shown in **FIG. 16** may comprises the same features as the arrangement shown in **FIG. 3****,** although without showing additional electrodes upbeam of and/or associated with the objective lens array 234 (which may include the control lens array 250). In an embodiment the electron optical apparatus shown in **FIG. 16** comprises a control lens array, and optionally other additional and associated electrodes upbeam of the objective lens array 234, as described above. In other embodiments, the electron optical apparatus is similar to another of the arrangements described above such as an arrangement comprising a macro scan deflector instead of the scan deflector array 260. In other embodiments, the electron optical apparatus comprises the features of another of the arrangements described above such as an arrangement shown in **FIG. 8** and **FIG. 9****.**

As shown in **FIG. 16****,** in an embodiment the electron optical apparatus comprises a source 201 configured to output a source beam 202 for generation of the multi-beam. As shown in **FIG. 16****,** in an embodiment the electron optical apparatus comprises an aperture array. The aperture array is configured to form a plurality of beams of the multi-beam from the source beam 202 by blocking a proportion of the source beam 202 from being projected towards the sample 208. Such an aperture array may be referred to as a beam limiting aperture array. In an embodiment the aperture array is comprised in the condenser lens array 231. In another arrangement the aperture array is located upbeam of the condenser lens array 231.

As shown in **FIG. 16****,** in an embodiment the electron optical apparatus comprises a detector (or monitoring detecting system) configured to measure at least a parameter of at least part of the blocked proportion of the source beam 202. In an embodiment the monitoring detecting system comprises an optical detector and a converter 60. The optical detector may comprise a camera 61. The camera is configured to detect light. In an embodiment the converter 60 is provided to convert the source beam 202 into light that can be detected by the optical detector.

As shown in **FIG. 16****,** in an embodiment the converter 60 is at an upbeam surface of the aperture array, which may be a beam limiting aperture array. In an embodiment the received source beam 202 comprises at least part of the proportion of the source beam 202 blocked by the aperture array. An embodiment of the invention is expected to allow monitoring of the source beam 202 without significantly affecting the multi-beam incident on the sample 208. The source beam 202 may be monitored inline, e.g. during an inspection or metrology process, for example using the monitoring detector.

As shown in **FIG. 16****,** in an embodiment the converter 60 comprises a coating 71. The coating 71 may come in a plurality of separate sections, for example in an array. Each element array may be associated with one or more of the apertures in the array. Alternatively the coating 71 may be contiguous. The coating 71 is provided between the apertures of the aperture array (which may be part of the condenser lens array 231). The coating 71 may comprise a material comprising YAG, for example, as described above.

In an embodiment the camera 61 is configured to read out the generated light with ex-situ, for example external to the column such as the vacuum chamber of the electron-optical device. As shown in **FIG. 16****,** in an embodiment the camera 61 and the converter 60 are arranged such that the camera 61 has a direct view of the converter 60. The converter may be in the direct line of sight of the optical detector. In an embodiment the light is directly detected.

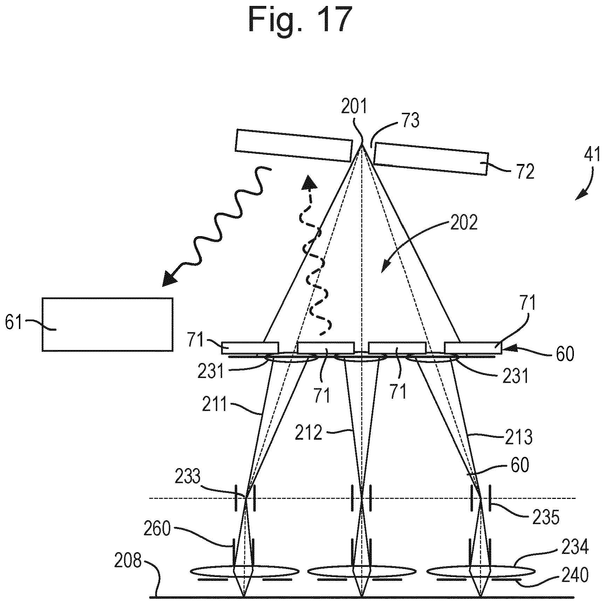

**FIG. 17** is a schematic diagram of exemplary multi-beam electron optical apparatus according to an embodiment. Such common features may take the same reference numbers and description of **FIG. 16****.** Features of the arrangement that are the same as the arrangement shown in **FIG. 16** are not repeated below. As shown in **FIG. 17****,** in an embodiment the electron optical apparatus comprises a light reflective element such as a mirror 72. The mirror 72 is configured to reflect light generated by the converter 60 towards the optical detector. In this embodiment, the monitoring detecting system comprises the converter 60, the mirror 72 and the light detector.

As shown in **FIG. 17****,** in an embodiment the mirror 72 is located around the source 201. The mirror 72 is configured to reflect the light in a position where is most convenient to place the detector. An embodiment of the invention is expected to allow the source beam 202 to be monitored without making the apparatus significantly mechanically harder, or more complex, to manufacture.

As shown in **FIG. 17****,** in an embodiment the mirror 72 is positioned in an upbeam direction of the converter 60. In an embodiment the mirror 72 is between the converter 60 and the source 201. The mirror 72 may be located in a volume that would otherwise be relatively empty. An embodiment of the invention is expected to allow the source beam 202 to be monitored without significantly affecting the mechanical design of parts of the apparatus used during an inspection or metrology process.

As shown in **FIG. 17****,** in an embodiment the mirror 72 comprises an aperture 73. The aperture 73 may be for accommodating the source 201, as shown in **FIG. 17****.** Additionally or alternatively the aperture 73 may be for accommodating the source beam 202. The mirror may be located in a downbeam direction of the source 201.

In general the mirror 72 is positioned relative to the optical detector and the converter 60 such that optical detector detects light generated at least in selected regions, for example all, of the surface of the converter 60. The mirror 72 need not be placed around the source 201, but to one side of the source and/or in an upbeam or (as already mentioned) downbeam direction of the source 201. The optical detector is desirably positioned in a straight line path of light from the converter 60 when reflected off the mirror 72. The mirror 72 may be curved or have more than one surface, for example may take the form of a Fresnel mirror, so long as the emitted light from the converter 60 reaches the optical detector.

In an embodiment the converter 60 and camera 61 shown in **FIG. 16** may be replaced by a monitoring detector charged detector such as a Faraday cup array or a CCD, which may be arrayed in an array for example one or more detectors for each aperture in the beam limiting aperture array, for example around one or more apertures of the beam limiting aperture array. (Thus the monitoring detecting system features the monitoring detector in place of for example the converter 60, the optical detector and the mirror 72). The apparatus may be run at a low current of electrons from the source 201 so as to reduce the effect of the Faraday cups or CCD undesirably charging up which could undesirably affect the multi-beam.

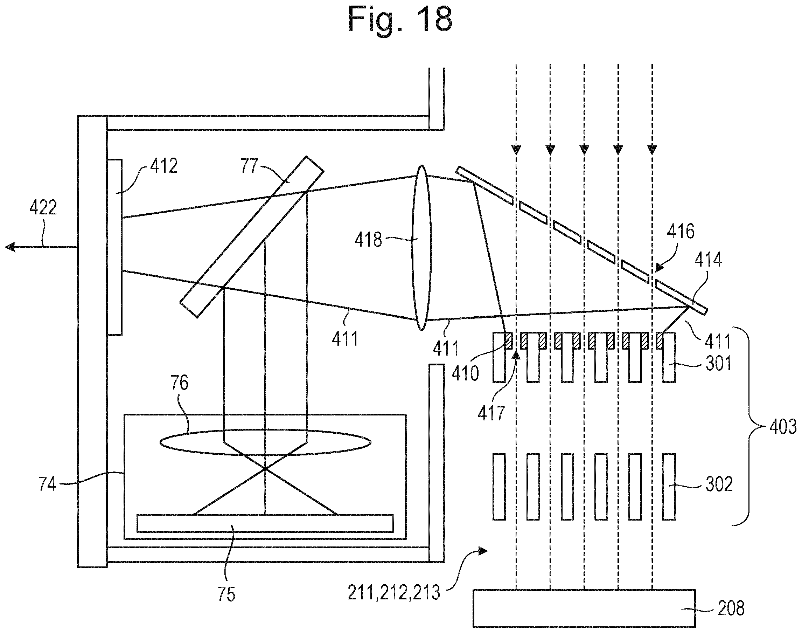

**FIG. 18** is a schematic diagram illustrating a portion of an electron optical device comprising a plurality of converters 410 and a light guiding arrangement. Features of the arrangement that are the same as the arrangement shown in **FIG. 8** are not repeated below. The apparatus comprises an electron device (or column) and a light sensing assembly.

In all and each of the arrangements shown and described with respect to FIGs. 10 to 17, and mentioned and derivable embodiments, the monitoring detecting system may generate a detection signal. The detection signal generated by the optical detector 75 may be used by the controller 50 or an element of the controller to control an element or component of the electron-optical device (or column) 41. The detection signal may comprise information regarding the relative positions of the sub-beams within the multi-beam such as the relative alignment of the sub-beams at the converter 60 or monitoring detector 64. The detection signal may be used to the controller or an element of the controller align the sub-beams for example by controlling one or more correctors of the electron-optical device 41. The invention is primarily described herein to monitor the sub-beams of the multibeam arrangement for the purposes of correcting alignment between sub-beams and between electron-optical components, even electron-optical elements, along the path of the multi-beam arrangement. Additionally or in the alternative, the invention may be used to monitor other types characteristics, such as of aberration, for correction or adjustment. Additionally or alternatively the sub-beams of the multi-beam arrangement may be measured for one or more of: focus aberrations, characteristics or even aberrations in source beam uniformity, and off-axis aberrations, such as field curvature, distortion and astigmatism. Correctors in the electron-optical device may be controlled to correct or at least reduce the size of one or more of these characteristics or aberrations.

As shown in **FIG. 18****,** in an embodiment the electron device comprises an objective lens array 403 configured to project the multi-beam onto locations on the sample 208. In an embodiment the electron device comprises a plurality of converters 410 configured to receive signal electrons emitted from the sample 208 and to generate light in response to the received signal particles. The converters 410 may be scintillators. The converter 410 may comprise a conversion material as described above in relation to the material of the converter 60.

In another arrangement the objective lens array 403 may additionally or alternatively be associated with another plate such as an electrode such as a lens electrode associated with the objective lens integrated in the objective lens array or upbeam of yet proximate to the objective lens such as a control lens array. In an arrangement additionally or alternatively a detector array is located upbeam of the objective lens array and any electron-optical element associated with the objective lens. The detector elements of the detector array may be associated with respective sub-beams. The detector elements may comprise charge detecting, scintillators and PIN detecting elements. In an arrangement in which the detector elements comprise scintillators, the detectors may be set to one side of the sub-beam paths so that the sub-beams pass to the side of respective detector elements.

A deflecting element may be between the detector array and the objective lens, such as a Wien filter e.g. a Wien filter array. Such a Wien filter permits sub-beams to pass through the Wien filter towards the sample undeflected but directs signal particles from the sample towards the detector elements. Optical converters, e.g. optical detectors, may be positioned to convert light generated by the scintillators into electronic signals., The optical converters may be coplanar and even in direct contact with the scintillating detector elements. Such optical converters are described in EP Application 21183803.2 filed on 5 July 2021, which filing is incorporated by reference at least with respect to the optical converters associated with the scintillating detectors and the architecture and use of detectors for detecting signal particles.

As shown in **FIG. 18****,** in an embodiment the electron device comprises a light guiding arrangement comprising a mirror 414. In the mirror 414 are defined a plurality of apertures 416 to allow passage of the multi-beam through the mirror 414 towards the sample 208.

The light guiding arrangement is configured to guide the light 411 generated by the converters 410 to the light sensing assembly. As shown in **FIG. 18****,** in an embodiment the light sensing assembly comprises an assessment sensor (e.g. light sensor 412) and an optical detector 75 each configured to detect the light 411 generated by the converters 410. The assessment sensor is configured to detect the light 411 during an inspection or metrology process, for example. In effect the assessment sensor is part of an assessment system for detecting signal particles. The assessment sensor is equivalent in function to the detector 240 of **FIG. 3****,** for example. The optical detector 75 is part of an additional branch configured to improve the inspection or metrology processes, for example.

As shown in **FIG. 18****,** in an embodiment the light sensing assembly comprises a beam splitter 77 configured to split the light 411 generated by the converters 410 into light beams directed towards the assessment sensor and towards the detector 75. Both the light sensor 412 and the detector 75 may be configured to detect different portions of the light 411 simultaneously. As shown in **FIG. 18****,** in an embodiment the light sensing assembly comprises an optical element 76, for example a lens. The optical element 76 is configured to act on the light 411 that is directed towards the detector 75. For example, the optical element 76 may focus the light onto the detector 75.

In an embodiment the apparatus comprises a controller configured to match detection signals of the assessment sensor to the locations on the sample 208 onto which the multi-beam was projected based on detection signals of the optical detector 75. For example the light sensor 412 may be for a sensor array for which it is desirable to align different parts of the light beam from the converters 410, associated with signal particles generated by different sub-beams, with a corresponding part, such as a sensor element of the sensor array, of the light sensor 412. The monitoring by the optical detector 75 may be used to calibrate and/or improve the accuracy of the signals detected by the light sensor 412. The optical detector 75 may be used to monitor alignment of the multi-beam, for example the position of the different parts of the light beam with respect to the optical detector 75 and its detecting elements. The position of the detecting elements of the optical detector 75 may be calibrated with the different parts, e.g. sensor elements, of the light sensor 412. The signal, e.g. detection signal, detected by the optical detector 75 may be used in a subsequent process or an ongoing process of improving the alignment of the multi-beam. The signal detected by the optical detector 75 may be used to control the components of the light sensing assembly such as the mirror 414 and/or the optics 418 which may comprise a lens. The components of the light sensing assembly may be controlled by the controller based on the detection signal to improve the alignment of the light from the converters 410 so that its different parts are better aligned with the parts, e.g. sensor elements, of the light sensor 412. The detection signal transmitted from the data line 422 more accurately distinguishes between signal particles generated by each sub-beam.

A multi-beam electron optical apparatus may comprise a gun aperture plate or Coulomb aperture array (not shown). The gun aperture plate is a plate in which apertures are defined. It is located in an electron-optical device downbeam of the source and before any other electron-optical device. In **FIG. 3** it would be located between the source 201 and the condenser lens array 231. The gun aperture plate, in operation, is configured to block off peripheral electrons of the source beam 202 to reduce Coulomb effects in the beam before the beam separator, for example in or associated with the condenser lens array. However, the gun aperture array may have fewer apertures than the condenser lens array and a number of apertures fewer than the number of beamlets that are downbeam in the multi-beam. As a gun aperture array is a type of aperture array and is spaced apart from other beam limiting aperture arrays, such as the condenser lens array and the objective lens array, it may be considered in the alignment procedure too.

A multi-beam electron optical apparatus may comprise a plurality of electron optical devices. The multi-beam electron optical apparatus may be a multi-column apparatus.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to up and low, upper and lower, lowest, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

References to elements being aligned along a beam path or sub-beam path are understood to mean that the respective elements are positioned along the beam path or sub-beam path.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron optical apparatus 40 (which may comprise an electron optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a charged particle-optical device may more specifically be defined as a charged particle-optical column. In other words, the device may be provided as a column. The column may thus comprise an objective lens array assembly as described above. The column may thus comprise a charged particle optical system as described above, for example comprising an objective lens array and optionally a detector array and/or optionally a condenser lens array. Optionally the charged particle device may comprise a source. The charged particle device may be comprised as a part of a charged-particle optical apparatus. Such a charged-particle optical apparatus comprises the charged particle device and a source (if not part of the charged particle device) and an actuatable stage for supporting the sample. The actuatable stage may be actuatable to move the sample relative the paths of the charged particles from the column. The charged particle apparatus may be locatable on the footprint in the chip fabrication facility. A charged particle system may comprise the charged particle apparatus and environmental conditioning systems and processors such as process racks which may be remote from the part of the system present on the apparatus footprint. Such environmental conditioning systems way comprises parts of a thermal conditioning system and part of a vacuum system.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 234, the condenser lens 231, correctors, and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a MEMS (i.e. using MEMS manufacturing techniques).

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on the charged particle beam emitted from the sample 208 in response to the charged particle beam.

Any element or collection of elements may be replaceable or field replaceable within the electron optical apparatus 40. The one or more charged particle-optical components in the electron optical apparatus 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses. Clause 1: A charged-particle optical apparatus configured to project a multi-beam of charged particles, the apparatus comprising: a charged particle device switchable between (i) an operational configuration in which the column is configured to project the multi-beam to a sample along an operational beam path extending from a source of the multi-beam to the sample and (ii) a monitoring configuration in which the device is configured to project the multi-beam to a detector along a monitoring beam path extending from the source to the detector; wherein the monitoring beam path diverts from the inspection beam path part way along the operational beam path.

Clause 2: The charged-particle optical apparatus of clause 1, wherein the device comprises at least one moveable component configured to move between an operational position corresponding to the operational configuration and a monitoring position corresponding to the monitoring configuration.

Clause 3: The charged-particle optical apparatus of clause 2, wherein the at least one moveable component comprises the detector.

Clause 4: The charged-particle optical apparatus of clause 2 or 3, wherein the monitoring position is between the source and the sample.

Clause 5: The charged-particle optical apparatus of any of clauses 2 to 4, wherein the at least one moveable component comprises a converter configured to receive the multi-beam output by the source and to generate light in response to the received multi-beam.

Clause 6: The charged-particle optical apparatus of clause 5, wherein the at least one moveable component comprises a light guiding arrangement configured to guide the light generated by the converter towards the detector.

Clause 7: The charged-particle apparatus of clause 5 or 6, wherein the at least one moveable component comprises a mirror configured in the monitoring position to direct the light generated by the converter to the detector.

Clause 8: The charged-particle apparatus of any of clauses 1 to 4, wherein the device comprises a converter in the path of the multi-beam to generate light beams in response to the multibeam and a mirror configured in the monitoring configuration to direct the light beams to the detector, desirably in the monitoring configuration.

Clause 9: The charged-particle apparatus of clause 7 or 8, wherein the converter remains in the same position in the operational configuration and in the monitoring position.

Clause 10: The charged-particle apparatus of clause 9, wherein in the converter are defined a plurality of apertures for passage of the paths of the multi-beam, desirably in an operational configuration.

Clause 11: The charged-particle optical apparatus of any of clauses 7 to 10, wherein defined in the mirror is a plurality of apertures configured to allow passage of the multi-beam through the mirror towards the sample, desirably in the operational configuration, wherein the mirror is configured to reflect light towards the detector.

Clause 12: The charged-particle apparatus of clause 11, wherein in the operational configuration the paths of the plurality of beams of the multi-beam pass through respective apertures defined in the mirror.

Clause 13: The charged-particle apparatus of clause 10 or 12, wherein in the monitoring configuration, the paths of the plurality of beams of the multi-beam are incident on the converter.

Clause 14: The charged-particle optical apparatus of any preceding clause, wherein the device comprises at least one deflector operable between an inspection setting corresponding to the operational configuration and a measurement setting corresponding to the monitoring configuration, wherein desirably the deflector is a macro deflector configured to operate on all beam paths of the multi-beam or the deflector is a deflector array comprising a plurality of deflector elements to operate on a path of respective beam paths of the multi-beam.

Clause 15: The charged-particle optical apparatus of any of clauses 2 to 14, wherein the at least one moveable component comprises one of the source and an objective lens array configured in the operational configuration to project the multi-beam onto the sample.

Clause 16: The charged-particle optical apparatus of clause 15, wherein in the operational configuration the multi-beam is aligned with lenses of the objective lens array and in the monitoring configuration the multi-beam is offset from the objective lens array, wherein desirably the apparatus comprises an actuator configured to actuate the apparatus between the operational configuration and the monitoring configuration.

Clause 17: A charged-particle optical apparatus configured to project a multi-beam of charged particles to a sample, the apparatus comprising: a source configured to output a source beam for generation of the multi-beam; an aperture array configured to form a plurality of beams of the multi-beam from the source beam by blocking a proportion of the source beam from being projected towards the sample; and a detector configured to measure at least a parameter of at least part of the blocked proportion of the source beam.

Clause 18: The charged-particle optical apparatus of clause 17, comprising a converter configured to receive the source beam output by the source and to generate light in response to the received source beam.

Clause 19: The charged-particle optical apparatus of clause 18, wherein the converter is at an up-beam surface of the aperture array, wherein desirably the received source beam comprises at least part of the proportion of the source beam blocked by the aperture array.

Clause 20: The charged-particle optical apparatus of clause 18 or 19, comprising a mirror configured to reflect light generated by the converter towards the detector.

Clause 21: The charged-particle optical apparatus of clause 20, wherein the mirror is positioned in an up-beam direction of the converter, wherein desirably the mirror is between the converter and the source.

Clause 22: The charged-particle optical apparatus of clause 20 or 21, wherein the mirror comprises an aperture for accommodating the source and/or the source beam.

Clause 23: A charged-particle optical apparatus configured to project a multi-beam of charged particles to a sample, the apparatus comprising: a charged-particle device comprising: an objective lens array configured to project the multi-beam onto locations on the sample; a plurality of converters configured to receive signal particles emitted from the sample and to generate light in response to the received signal particles; and a light guiding arrangement comprising a mirror defining a plurality of apertures to allow passage of the multi-beam through the mirror towards the sample; and a light sensing assembly to which the light guiding arrangement is configured to guide the light generated by the converters, wherein the light sensing assembly comprises: an assessment sensor and a detector each configured to detect the light generated by the converters; and a beam splitter configured to split the light generated by the converters into light beams for the assessment sensor and the detector.

Clause 24: The charged-particle optical apparatus of clause 23, comprising a controller configured to match detection signals of the assessment sensor to the locations on the sample onto which the multi-beam was projected based on detection signals of the detector, wherein desirably the converters are scintillators.

Clause 25: The charged-particle optical apparatus of any preceding clause, wherein the detector is configured to detect light.

Clause 26: The charged-particle optical apparatus of any of clauses 1 to 19 and 23 to 25, wherein the detector is configured to detect charged particles.

Clause 27: The charged-particle optical apparatus of clause 26, wherein the detector comprises one of a Faraday cup array, a charge-coupled device and a direct light detector device comprising a converter configured to generate light in response to a charged particle, and an adjoining optical detector, preferably in contact with the converter, configured to directly convert the generated optical signal generated by the converter into an electrical signal.

Clause 28: The charged-particle optical apparatus of any preceding clause, wherein the detector is configured to measure at least one of uniformity of the multi-beam, alignment of the multibeam and an aberration of the multi-beam.

Clause 29: The charged-particle optical apparatus of clause 28, wherein the aberration is at least one of field curvature, distortion and astigmatism.

Clause 30: The charged-particle optical apparatus of any preceding clause wherein the source is configured to emit electrons.

Clause 31: A method to project a multi-beam of charged particles, the method comprising: using a charged particle device in an operational configuration to project the multi-beam to a sample along an operational beam path from a source of the multi-beam to the sample; and using the device in a monitoring configuration to project the multi-beam to a detector along a monitoring beam path extending from the source to the detector; wherein the monitoring beam path diverts from the operational beam path part way along the operational beam path.

Clause 32: A method of projecting a multi-beam of charged particles, the method comprising: in an operational configuration projecting the multi-beam to a sample along an operational beam path from a source of the multi-beam to the sample; and in a monitoring configuration projecting the multi-beam to a detector along a monitoring beam path from the source to the detector and diverting the monitoring beam path from the operational beam path part way along the operational beam path.

Clause 33: A method to project a multi-beam of charged particles to a sample, the method comprising: using a source to output a source beam of the multi-beam; using an aperture array to form a plurality of beams of the multi-beam from the source beam by blocking a proportion of the source beam from being projected towards the sample; and using a detector to measure at least a parameter of at least part of the blocked proportion of the source beam.

Clause 34: A method of projecting a multi-beam of charged particles to a sample, the method comprising: outputting a source beam of the multi-beam form a source; forming a plurality of beams of the multi-beam from the source beam by blocking at an aperture array a proportion of the source beam from being projected towards the sample; and measuring at least part of the blocked proportion of the source beam, desirably using a detector.

Clause 35: A method to project a multi-beam of charged particles to a sample, the method comprising: using an objective lens array configured to project the multi-beam onto locations on the sample; using a plurality of converters, desirably scintillators, to receive signal particles emitted from the sample and to generate light in response to the received signal particles; using a light guiding arrangement to guide the light generated by the converters to a light sensing assembly, wherein the light guiding arrangement comprises a mirror defining a plurality of apertures to allow passage of the multi-beam through the mirror towards the sample; and using a beam splitter to split the light generated by the converters into a plurality of light beams for an assessment sensor and a detector; and using the assessment sensor and the detector to detect the light generated by the converters.

Clause 36: A method of projecting a multi-beam of charged particles to a sample, the method comprising: projecting the multi-beam onto locations on the sample, desirably using an objective lens array; receiving signal particles emitted from the sample and generating light in response to the received signal particles, desirably using a plurality of converters, desirably scintillators; guiding the light generated to a light sensing assembly using a light guiding arrangement, wherein the light guiding arrangement comprises a mirror in which is defined a plurality of apertures, allowing passage of the multi-beam through the mirror towards the sample; and splitting the light generated into a plurality of light beams desirably using a beam splitter, preferably for an assessment sensor and a detector; and detecting the generated light, desirably using the assessment sensor and the detector.

## Claims

1. A charged-particle optical apparatus configured to project a multi-beam of charged particles, the apparatus comprising:
a charged particle device switchable between (i) an operational configuration in which the column is configured to project the multi-beam to a sample along an operational beam path extending from a source of the multi-beam to the sample and (ii) a monitoring configuration in which the device is configured to project the multi-beam to a detector along a monitoring beam path extending from the source to the detector;
wherein the monitoring beam path diverts from the inspection beam path part way along the operational beam path.

2. The charged-particle optical apparatus of claim 1, wherein the device comprises at least one moveable component configured to move between an operational position corresponding to the operational configuration and a monitoring position corresponding to the monitoring configuration.

3. The charged-particle optical apparatus of claim 2, wherein the at least one moveable component comprises the detector.

4. The charged-particle optical apparatus of claim 2 or 3, wherein the monitoring position is between the source and the sample.

5. The charged-particle optical apparatus of any of claims 2 to 4, wherein the at least one moveable component comprises a converter configured to receive the multi-beam output by the source and to generate light in response to the received multi-beam.

6. The charged-particle optical apparatus of claim 5, wherein the at least one moveable component comprises a light guiding arrangement configured to guide the light generated by the converter towards the detector.

7. The charged-particle apparatus of claim 5 or 6, wherein the at least one moveable component comprises a mirror configured in the monitoring position to direct the light generated by the converter to the detector.

8. The charged-particle apparatus of claim 7, wherein the converter remains in the same position in the operational configuration and in the monitoring position.

9. The charged-particle apparatus of claim 8, wherein in the converter are defined a plurality of apertures for passage of the paths of the multi-beam, desirably in an operational configuration.

10. The charged-particle optical apparatus of any of claims 7 to 9, wherein defined in the mirror is a plurality of apertures configured to allow passage of the multi-beam through the mirror towards the sample, desirably in the operational configuration, wherein the mirror is configured to reflect light towards the detector.

11. The charged-particle apparatus of claim 10, wherein in the operational configuration the paths of the plurality of beams of the multi-beam pass through respective apertures defined in the mirror.

12. The charged-particle apparatus of claim 9 or 11, wherein in the monitoring configuration, the paths of the plurality of beams of the multi-beam are incident on the converter.

13. The charged-particle optical apparatus of any preceding claim, wherein the device comprises at least one deflector operable between an inspection setting corresponding to the operational configuration and a measurement setting corresponding to the monitoring configuration.

14. The charged-particle optical apparatus of any of claims 2 to 13, wherein the at least one moveable component comprises one of the source and an objective lens array configured in the operational configuration to project the multi-beam onto the sample.

15. The charged-particle optical apparatus of claim 14, wherein in the operational configuration the multi-beam is aligned with lenses of the objective lens array and in the monitoring configuration the multi-beam is offset from the objective lens array, wherein desirably the apparatus comprises an actuator configured to actuate the apparatus between the operational configuration and the monitoring configuration.
